# DEMANDE DE BREVET EUROPEEN

(11) **EP 0 623 809 A1**
(43) Date de publication de la demande: **09.11.1994**
(21) Numéro de dépôt: 94400968.7
(22) Date de dépôt: 04.05.1994
(51) Int. Cl.: G01D 11/12

(54) **Perfectionnement aux moyens d'amortissement de logomètres**

(30) Priorité: 04.05.1993 FR 9305281
(71) Demandeur: JAEGER, F-92000 Nanterre (FR)
(72) Inventeur: Bezard, Jean-Jacques, F-78400 Chatou (FR)
(74) Mandataire: Martin, Jean-Jacques

(57) **Abrégé**

La présente invention concerne un logomètre, notamment pour tableau de bord de véhicule automobile, du type comprenant un arbre (16) guidé à rotation, un aimant (18) solidaire de l'arbre, une chambre (13) contenant un liquide d'amortissement et qui loge l'aimant (18), caractérisé par le fait que le liquide d'amortissement est formé de ferrofluide (20).

## Description

La présente invention concerne le domaine des logomètres, tout particulièrement les logomètres utilisés dans les tableaux de bord de véhicules automobiles.

On sait que les logomètres sont des dispositifs comprenant plusieurs bobines croisées d'axes magnétiques coplanaires, soit de préférence deux bobines croisées à 90°, un arbre perpendiculaire au plan des axes des bobines, guidé à rotation et un aimant solidaire de l'arbre placé à l'intérieur des bobines. Une aiguille indicatrice externe aux bobines est solidaire de l'arbre. Des moyens de commande appliquent des signaux électriques aux bobines.

Chacune des bobines génère un champ magnétique proportionnel au courant qui la traverse. L'aimant est généralement bipolaire et se positionne selon la résultante de ces champs. Pour un logomètre à deux bobines, l'angle défini par l'aiguille indicatrice, par rapport à une position d'origine est donc déterminé par la relation tan⁻¹ I₁/I₂, dans laquelle I₁ et I₂ représentent une valeur proportionnelle aux ampères-tours circulant respectivement dans les bobines.

Dans le domaine automobile, les logomètres à grande déviation sont utilisés généralement pour visualiser une vitesse ou le nombre de tours de rotation du moteur. Les logomètres à grande déviation comprennent généralement un spiral de rappel solidaire de l'arbre. Dans les logomètres à petite déviation, le spiral de rappel est généralement remplacé par un second aimant qui coopère avec l'aimant principal précité.

L'homme de l'art sait par ailleurs qu'il est souvent nécessaire d'amortir le déplacement de l'arbre et de l'aiguille associée pour permettre l'affichage d'une information stable.

A cet effet, on a proposé de placer dans l'espace interne des bobines de logomètre une coupelle fixe contenant un liquide d'amortissement, tel que de l'huile de silicone, dans lequel baigne l'aimant.

Toutefois, cette solution ne donne pas totalement satisfaction. En effet on constate parfois que le liquide d'amortissement fuit à l'extérieur de la coupelle, en particulier dans des conditions thermiques élevées ou encore après usure des garnitures d'étanchéité de la coupelle.

Ces fuites sont principalement dues à un effet de "pompage" de l'arbre lorsqu'il entre en résonance ou en vibration.

La présente invention a maintenant pour but d'éliminer cet inconvénient.

Ce but est atteint dans le cadre de la présente invention grâce à un logomètre du type comprenant un arbre guidé à rotation, un aimant solidaire de l'arbre, une chambre contenant un liquide d'amortissement et qui loge l'aimant,
caractérisé par le fait que le liquide d'amortissement est formé de ferrofluide.

D'autres caractéristiques, buts et avantages de la présente invention apparaîtront à la lecture de la description détaillée qui va suivre, et en regard des dessins annexés donnés à titre d'exemple non limitatif et sur lesquels :
- la figure 1 représente une vue schématique, partiellement en coupe, d'un logomètre conforme à la présente invention, et
- la figure 2 représente une vue en plan d'un aimant utilisé dans le cadre de la présente invention.

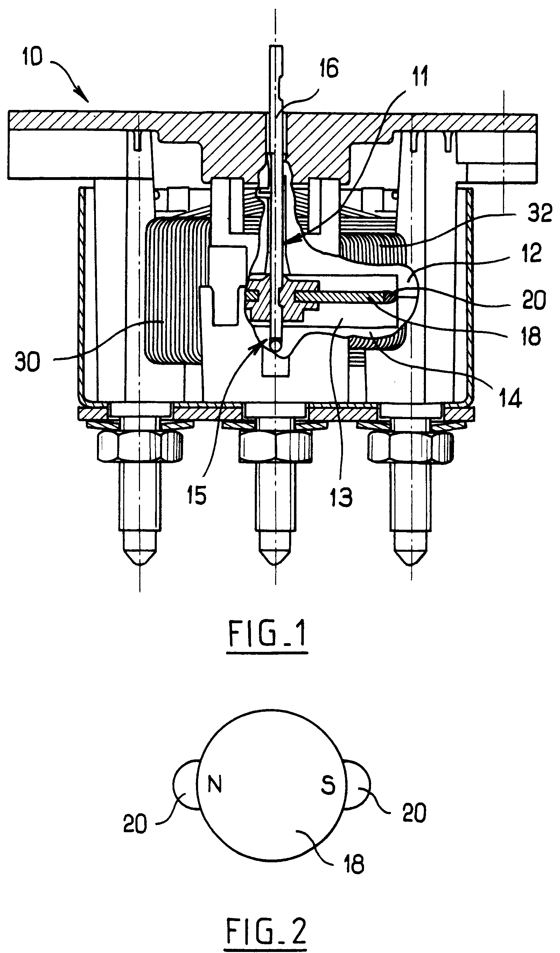

On a schématisé sur la figure 1 annexée un logomètre 10 comprenant deux pièces de bati 12, 14 sur lesquelles sont placées deux bobines 30, 32 croisées à 90°, un arbre 16 guidé à rotation et un aimant 18 solidaire de l'arbre 16, placé à l'intérieur d'une chambre 13 formée par les pièces 12, 14. L'aimant 18 est de préférence un aimant bipolaire à aimantation radiale comme cela est visible sur la figure 2.

Les deux pièces de bati 12, 14 sont fixes, c'est-à-dire solidaires du carter de logomètre.

Les pièces de bati 12, 14 représentées sur la figure 1 ne sont données qu'à titre d'exemple non limitatif. Elles peuvent faire l'objet de nombreuses variantes de réalisation.

L'essentiel est que la chambre 13 définie par les pièces 12, 14 autorise une rotation de l'aimant 18 avec l'arbre 16.

Comme on le voit sur la figure 1, de préférence, les pièces de bati 12, 14 définissent chacune un palier 11, 15 pour l'arbre 16.

Dans le cadre de la présente invention, la chambre 13 contient du ferrofluide 20.

On rappelle que les ferrofluides sont formés de particules ferromagnétiques solides, d'un liquide support diélectrique et généralement d'un stabilisateur.

Le liquide support confère au ferrofluide ses propriétés hydrodynamiques et thermiques. Dans le cadre de la présente invention, le liquide support est formé avantageusement d'huile silicone.

Quant à l'agent stabilisateur, celui-ci a pour fonction essentielle d'éviter l'agrégation des particules ferromagnétiques par suite d'une action dipolaire. L'agent stabilisateur est formé généralement d'acide oléique.

On notera que dans le cadre de la présente invention, il n'est pas nécessaire de remplir la chambre 13 en matériau ferrofluide 20.

Comme on le voit sur la figure 2, le matériau ferrofluide se confine à proximité des poles de l'aimant 18. Il suffit par conséquent que la chambre 13 contienne une quantité de ferrofluide suffisante pour remplir l'espace défini entre les poles de l'aimant 18 et la paroi périphérique en regard de la chambre 13, c'est-à-dire des pièces de bati 12, 14, pour assurer un amortissement sur le mouvement de rotation de l'aimant 18 et de l'arbre 16.

En ne remplissant pas totalement la chambre 13 on évite toute fuite, par les paliers 11, 15 de l'arbre 16, notamment en cas d'élévation de température, ou en cas de vibrations.

L'utilisation de ferrofluide pour amortir le déplacement de l'arbre d'un logomètre s'avère particulièrement avantageuse. En effet grâce à l'attraction de l'aimant sur les particules ferromagnétiques, on évite toute fuite du ferrofluide formant liquide amortisseur à l'extérieur de la coupelle.

Au cours d'essais et études, la Demanderesse a constaté qu'il était avantageux de prévoir des rainures, préférentiellement annulaires concentriques, dans la chambre 13, pour confiner le ferrofluide.

Il est également avantageux de prévoir un état de surface rugueux dans la chambre 13, au niveau du lieu de confinement souhaité pour le ferrofluide (lequel état de surface rugueux peut par exemple être obtenu par attaque chimique) et/ou de déposer un vernis type épilamage ou équivalent en bordure du lieu de confinement souhaité.

Bien entendu la présente invention n'est pas limitée au mode de réalisation particulier qui vient d'être décrit mais s'étend à toute variante conforme à son esprit.

En particulier, la présente invention n'est pas limitée à l'utilisation d'un aimant circulaire comme représenté sur la figure 2, mais s'étend à toutes variantes, notamment aux aimants comportant des méplats ou équivalents.

## Revendications

1. Logomètre, notamment pour tableau de bord de véhicule automobile, du type comprenant un arbre (16) guidé à rotation, un aimant (18) solidaire de l'arbre, une chambre (13) contenant un liquide d'amortissement et qui loge l'aimant (18), caractérisé par le fait que le liquide d'amortissement est formé de ferrofluide (20).

2. Logomètre selon la revendication 1, caractérisé par le fait que le ferrofluide comprend des particules ferromagnétiques et un liquide support.

3. Logomètre selon la revendication 2, caractérisé par le fait que le liquide support est formé d'huile silicone.

4. Logomètre selon l'une des revendications 2 ou 3, caractérisé par le fait que le ferrofluide comprend en outre un agent stabilisateur.

5. Logomètre selon la revendication 4 caractérisé par le fait que l'agent stabilisateur est formé d'acide oléique.

6. Logomètre selon l'une des revendications 1 à 5, caractérisé par le fait que la chambre (13) n'est pas remplie totalement de ferrofluide.

7. Logomètre selon l'une des revendications 1 à 6, caractérisé par le fait que la chambre (13) comporte des rainures, de préférence annulaires concentriques.

8. Logomètre selon l'une des revendications 1 à 7, caractérisé par le fait que la chambre (13) présente un état de surface rugueux au niveau du lieu de confinement du ferrofluide.

9. Logomètre selon l'une des revendications 1 à 8, caractérisé par le fait que la chambre (13) possède un vernis type épilamage ou équivalent en bordure du lieu de confinement du ferrofluide.
